# EUROPÄISCHE PATENTSCHRIFT

(11) **EP 3 069 414 B1**
(45) Veröffentlichungstag und Bekanntmachung des Hinweises auf die Patenterteilung: **25.07.2018**
(21) Anmeldenummer: 14818866.7
(22) Anmeldetag: 22.10.2014
(51) Int. Cl.: H01R 9/26, H01R 13/629

(54) **PRÜFSTECKERBLOCK**
TEST PLUG BLOCK
BLOC DE FICHES D'ESSAI

(30) Priorität: 15.11.2013 DE 102013019066
(43) Veröffentlichungstag der Anmeldung: 21.09.2016
(73) Patentinhaber: Phoenix Contact GmbH & Co. KG, 32825 Blomberg (DE)
(72) Erfinder: KLOPPENBURG, Christian, 33142 Büren Wewelsburg (DE)
(74) Vertreter: Gesthuysen Patent- und Rechtsanwälte
(86) Internationale Anmeldenummer: PCT/EP2014/002859
(87) Internationale Veröffentlichungsnummer: WO 2015/070946

(56) Entgegenhaltungen:
- EP-A1- 0 825 684
- EP-A2- 1 921 715
- DE-A1-102008 054 950
- DE-A1-102011 113 333

## Beschreibung

Die Erfindung betrifft einen Prüfsteckerblock zum Aufstecken auf einen Reihenklemmenblock, mit einer Mehrzahl von miteinander verbundenen Prüfsteckern und zwei auf beiden Seiten der Mehrzahl von Prüfsteckern angeordneten Befestigungsteilen, die über ein Griffstück miteinander verbunden sind, wobei die Befestigungsteile jeweils ein Gehäuse mit einem Einsteckabschnitt aufweisen, der in einen Aufnahmeabschnitt einsteckbar ist, der im Klemmengehäuse einer Befestigungsklemme des Reihenklemmenblocks ausgebildet ist.

Elektrische Reihenklemmen sind seit Jahrzehnten bekannt und werden millionenfach bei der Verdrahtung elektrischer Anlagen und Geräte verwendet. Die Klemmen werden meist auf Tragschienen aufgerastet, welche ihrerseits häufig in einer Mehrzahl in einem Schaltschrank angeordnet sind. In der Schalt-, Meß- und Regeltechnik sind Durchgangsklemmen mit Trennmöglichkeit der Standard. Die bei derartigen Durchgangsklemmen durch die Ausbildung einer Trennstelle im Strombalken realisierte Trennmöglichkeit ermöglicht es dabei, unterschiedliche Stecker mit unterschiedlichen Funktionen in das Klemmengehäuse der Reihenklemme einzustecken, die dann an der Trennstelle den Strombalken kontaktieren. Als Stecker können dabei neben einfachen Trennsteckern oder Durchgangsverbindern insbesondere auch Prüf- oder Teststecker verwendet werden, die spezielle Bauelemente aufweisen können und ein Überprüfen der ordnungsgemäßen Funktion des an die Reihenklemme angeschlossenen Stromkreises ermöglichen.

Elektrische Reihenklemmen, die in der Regel scheibenförmig ausgebildet sind, werden häufig mit mehreren anderen elektrischen Reihenklemmen zu einem Reihenklemmenblock zusammengesteckt und auf eine Tragschiene aufgerastet oder in einem Wandausschnitt, beispielsweise eines Schaltschranks, montiert. Entsprechend werden auch die einzelnen Prüfstecker, die in ihrer Breite in der Regel der Breite der Reihenklemmen entsprechen, zu einem Prüfsteckerblock verbunden und gemeinsam auf einen korrespondierenden Reihenklemmenblock aufgesetzt. Hierbei besteht die Anforderung, dass die Anzahl der miteinander verbundenen Reihenklemmen sowie die Anzahl der miteinander zu einem Prüfsteckerblock zusammengefassten Prüfstecker frei wählbar ist. Gleichzeitig sollen jedoch die zu einem Prüfsteckerblock zusammengefassten Prüfstecker möglichst einfach gemeinsam betätigt, d. h. gemeinsam auf den Reihenklemmenblock aufgesteckt werden können.

Die EP 1 921 715 A2 offenbart eine Reihenklemme, ein Prüfstecker und ein aus einer Mehrzahl von nebeneinander angeordneten Reihenklemmen und einer entsprechenden Anzahl von Prüfsteckern bestehenden Prüfklemmblock. Durch die Verwendung von zwei Befestigungsklemmen und zwei Befestigungsteilen, die jeweils auf beiden Seiten des Reihenklemmenblocks bzw. des Prüfsteckerblocks angeordnet sind, ist die Anzahl der Reihenklemmen sowie die Anzahl der Prüfstecker, die zu einem Reihenklemmenblock bzw. einem Prüfsteckerblock zusammengefasst werden können, frei wählbar. Die beiden Befestigungsteile sind über ein Griffstück miteinander verbunden, so dass der Prüfsteckerblock zusammen mit den beiden Befestigungsteilen einfach und bequem mit Hilfe des Griffstückes in den Reihenklemmenblock und die beiden Befestigungsklemmen ein- bzw. aufgesteckt werden kann. Das Griffstück ist dabei am oberen Ende der Befestigungsteile angeordnet, die eine größere Höhle als die Prüfstecker aufweisen, so dass das Griffstück die zwischen den beiden Befestigungsteilen angeordneten Prüfstecker überspannt und dadurch bequem mit einer Hand gegriffen werden kann.

Um beim Einstecken des Prüfsteckers in die Prüföffnung definierte Kontaktzustände zu gewährleisten, sind bei der aus der EP 1 921 715 A2 bekannten elektrischen Reihenklemme die Strombalken so ausgebildet, dass sie zwei Kontaktbereiche bilden, die in Aufsteckrichtung eines Prüfsteckers hintereinander angeordnet sind. Bei den bekannten Reihenklemmen ist somit die von den einen Endbereichen der Stromschienen gebildete Trennstelle zweistufig ausgebildet. Durch die Ausbildung eines definierten zweiten Kontaktbereichs, der in Einführrichtung des Kontaktsteckers vor dem ersten Kontaktbereich angeordnet ist, ist gewährleistet, dass es beim Einführen des Kontaktsteckers zunächst zu einer sicheren elektrischen Verbindung zwischen dem Kontaktstecker und den beiden Strombalken kommt, bevor der erste Kontaktbereich beim weiteren Einführen des Kontaktsteckers geöffnet wird, wodurch die beiden Strombalken dann elektrisch voneinander getrennt werden.

Den zuvor beschriebenen, bekannten Reihenklemmen bzw. Prüfklemmblöcken ist gemeinsam, dass die beiden Strombalken einander kontaktieren, so dass die Leiteranschlusselemente elektrisch leitend miteinander verbunden sind, wenn kein Stecker in die Reihenklemme eingesteckt ist. Ist dagegen ein Stecker (vollständig) in die Reihenklemme eingesteckt, so ist der Kontaktbereich aufgetrennt, so dass auch die Leiteranschlusselemente elektrisch voneinander getrennt sind.

Häufig weisen die einzelnen Prüfstecker des Prüfsteckerblocks unterschiedlich lange Kontaktstecker auf. Beim Aufstecken des Prüfsteckerblocks tauchen dann zunächst die längeren Kontaktstecker einzelner Prüfstecker in die korrespondierenden Öffnungen im Klemmengehäuse der Reihenklemmen ein und kontaktieren dort den in Aufsteckrichtung des Prüfsteckers ersten, voreilenden Kontaktbereich der beiden Strombalken. Wird der Prüfsteckerblock weiter auf den Reihenklemmenblock aufgesteckt, so tauchen die längeren Kontaktstecker in den zweiten Kontaktbereich ein, wodurch dieser Kontaktbereich geöffnet wird, so dass die elektrisch leitende Verbindung zwischen den beiden Strombalken - und damit auch zwischen den beiden mit den Strombalken verbundenen Leiteranschlusselementen - unterbrochen wird. Sind die Kontaktstecker elektrisch leitend, so wird dadurch die Stromführung über den Prüfstecker umgeleitet. Wird der Prüfsteckerblock weiter auf den Reihenklemmenblock aufgesteckt, so kontaktieren als nächstes die kürzeren Kontaktstecker zunächst entsprechend den voreilenden Kontaktbereich in den Reihenklemmen, bevor auch die kürzeren Kontaktstecker den zweiten Kontaktbereich öffnen und dadurch auch die Stromführung dieser Reihenklemmen unterbrochen und ggf. über die Prüfstecker umgeleitet wird.

Beim Herausziehen des Prüfsteckerblocks aus dem Reihenklemmenblock ist es bei vielen Anwendungsfällen erforderlich oder zumindest gewünscht, dass die längeren Kontaktstecker den Kontaktbereich der zugeordneten Reihenklemmen noch auftrennen, während die kürzeren Kontaktstecker schon aus dem zweiten Kontaktbereich der zugeordneten Reihenklemmen herausgezogen sind, so dass sich die beiden Strombalken der entsprechenden Reihenklemme wieder kontaktieren, wodurch die Stromführung über die Reihenklemme erfolgt. Hierbei besteht bei den bekannten Prüfklemmenblöcken jedoch die Gefahr, dass durch ein zu schnelles oder ungleichmäßiges Herausziehen des Prüfsteckerblocks aus dem Reihenklemmenblock die zuvor beschriebene Abfolge, wonach die Kontaktbereiche einiger Reihenklemmen durch die längeren Kontaktstecker noch geöffnet sind, während über andere Reihenklemmen, denen Prüfstecker mit kürzeren Kontaktsteckern zugeordnet sind, bereits ein Stromübergang erfolgt, nicht sicher oder einwandfrei gewährleistet ist. Hierdurch kann sich ein instabiler bzw. undefinierter elektronischer Zustand einzelner Reihenklemmen des Reihenklemmenblocks ergeben.

Der vorliegenden Erfindung liegt daher die Aufgabe zugrunde, einen Prüfsteckerblock anzugeben, bei dem die zuvor beschriebenen Nachteile vermieden werden. Darüber hinaus soll das Handling des Prüfsteckerblocks, insbesondere das Aufstecken des Prüfsteckerblocks auf den Reihenklemmenblock, für einen Monteur möglichst einfach und komfortabel sein.

Diese Aufgabe ist bei einem eingangs beschriebenen Prüfsteckerblock mit den Merkmalen des Patentanspruchs 1 dadurch gelöst, dass der Einsteckabschnitt mindestens eines Befestigungsteils mindestens zwei Rastelemente aufweist, die mit korrespondierenden Gegenrastelementen der Befestigungsklemme zusammen eine erste Rastposition und eine zweite Rastposition des Befestigungsteils in der Befestigungsklemmen festlegen, wobei die beiden Rastpositionen in Aufsteckrichtung des Prüfsteckerblocks hintereinander angeordnet sind. Durch die Ausbildung der vorzugsweise als Rasthaken ausgebildeten Rastelemente sind zwei Rastpositionen möglich, wodurch der Prüfsteckerblock sowohl in seiner vollständig aufgesteckten Position als auch in einer zweiten, teilweise herausgezogenen Position verriegelt werden kann. Durch die zweite Rastposition kann dabei sichergestellt werden, dass der Prüfsteckerblock zunächst nur so weit aus dem Reihenklemmenblock herausgezogen wird, dass kürzere Kontaktstecker einzelner Prüfstecker die Kontaktbereiche der zugeordneten Reihenklemmen nicht mehr öffnen, während die Kontaktbereiche anderer Reihenklemmen durch die längeren Kontaktstecker der diesen Reihenklemmen zugeordneten Prüfstecker noch geöffnet sind.

Um eine gewollte Entriegelung der beiden Rastpositionen zu ermöglichen, ist außerdem im Gehäuse des mindestens einen Befestigungsteils ein Entriegelungselement verschiebbar angeordnet, das durch eine Drehbewegung des Griffstücks aus einer Grundposition in eine erste Entriegelungsposition und in eine zweite Entriegelungsposition verbringbar ist, wobei in der ersten Entriegelungsposition eine Verriegelung der ersten Rastposition und in der zweiten Entriegelungsposition eine Verriegelung der zweiten Rastposition durch das Entriegelungselement gelöst ist. Wird das Entriegelungselement in die erste Entriegelungsposition gebracht, so wird die Verriegelung zwischen den Rastelementen und den Gegenrastelementen der ersten Rastposition gelöst, so dass der Prüfsteckerblock etwas aus dem Reihenklemmenblock heraus gezogen werden kann. Da das Herausziehen des Prüfsteckerblocks aus dem Reihenklemmenblock durch die zweite Rastposition begrenzt wird, muss zum vollständigen Herausziehen des Prüfsteckerblocks zunächst das Entriegelungselement in die zweite Entriegelungsposition verbracht werden, wodurch die zweite Rastposition gelöst wird, so dass dann der Prüfsteckerblock vollständig aus dem Reihenklemmenblock herausgezogen werden kann.

Dadurch, dass die Verschiebung des Entriegelungselements durch eine Drehbewegung des Griffteils erzeugt wird, ist es möglich, das Entriegeln der beiden Rastpositionen und das Abziehen des Prüfsteckerblocks vom Reihenklemmenblock mit nur einer Hand und ohne Umgreifen durchzuführen, was die Handhabung für den Monteur besonders einfach macht. Die Umwandlung der gewollten Drehbewegung des Griffstücks in eine translatorische Bewegung des Entriegelungselements kann beispielsweise mittels eines Exzenterantriebs erfolgen, über den das Griffstück mit dem Entriegelungselement verbunden ist.

Das Handling des Prüfsteckerblocks, insbesondere das Aufstecken des Prüfsteckerblocks auf den Reihenklemmenblock, wird dadurch für einen Monteur weiter erleichtert, dass mindestens ein Befestigungsteil mindestens ein Begrenzungselement aufweist, das die mögliche Drehung des Griffstücks relativ zum Gehäuse begrenzt.

Wie eingangs ausgeführt worden ist, wird ein aus mehreren nebeneinander angeordneten Reihenklemmen und zwei auf beiden Seiten der Reihenklemmen angeordneten Befestigungsklemmen bestehender Reihenklemmenblock in der Regel auf einer Tragschiene aufgerastet, die in einem Schaltschrank befestigt ist. Alternativ dazu kann ein derartiger Reihenklemmenblock auch direkt in einer entsprechenden Öffnung in einer Schrankwand eingesetzt sein. In beiden Anwendungsfällen wird dabei der Prüfsteckerblock in der Regel horizontal auf den Reihenklemmenblock aufgesteckt, wozu ein Benutzer den erfindungsgemäßen Prüfsteckerblock mit einer Hand am Griffstück hält und dann mit einer horizontalen Steckbewegung auf den Reihenklemmenblock aufsteckt.

Insbesondere dann, wenn der Prüfsteckerblock eine etwas größere Anzahl an Prüfsteckern aufweist, kann es aufgrund des Eigengewichts des Prüfsteckerblocks dazu kommen, dass die dem Griffstück abgewandte Vorderseite des Prüfsteckerblocks aufgrund dessen Eigengewicht nach unten kippt, wenn der Benutzer den Prüfsteckerblock am Griffstück festhält, d.h. der Prüfsteckerblock kann in Uhrzeigersinn um die Drehachse des Griffstücks verkippen. Ein derartiges Verkippen des Prüfsteckerblocks würde das einfache Aufstecken des Prüfsteckerblocks auf den Reihenklemmenblock mit nur einer Hand erschweren, da dann eine einfache horizontale Aufsteckbewegung, bei der der Prüfsteckerblock nur mit einer Hand am Griffstück festgehalten wird, nicht mehr möglich wäre. Dadurch, dass bei dem erfindungsgemäßen Prüfsteckerblock mindestens ein Befestigungsteil mindestens ein die Drehbewegung des Griffstücks begrenzendes Begrenzungselement aufweist, wird die Gefahr des zuvor beschriebenen ungewollten Verkippens des Prüfsteckerblocks um die Drehachse des Griffstücks beim Aufstecken verhindert; es ist somit eine mechanische Selbsthaltung realisiert. Der Benutzer kann den Prüfsteckerblock einfach mit einer Hand am Griffstück festhalten und durch eine horizontale Bewegung auf den Reihenklemmenblock aufstecken.

Neben dem ungewollten Verkippen der Vorderseite des Prüfsteckerblocks um die Drehachse des Griffstücks wird durch die Ausbildung des Begrenzungselements auch eine ungewollte Verschiebung der Entriegelungselemente im Gehäuse der beiden Befestigungsteile verhindert, so dass sich die Entriegelungselemente beim Aufstecken des Prüfsteckerblocks auf den Reihenklemmenblock nicht in einer undefinierten Position befinden.

Als Begrenzungselement kann beispielsweise ein ausreichend starkes Federelement, insbesondere eine Kugeldruckfeder verwendet werden, deren Federkraft einer ungewollten Drehbewegung des Griffstücks relativ zum Gehäuse und damit einem Verkippen des Prüfsteckerblocks aufgrund seines Eigengewichts entgegen wirkt. Vorzugsweise sind in dem Gehäuse des Befestigungsteils jedoch mindestens ein Anschlag und ein korrespondierender Gegenanschlag als Begrenzungselemente vorgesehen, wobei der Anschlag fest im Gehäuse angeordnet und der Gegenanschlag mit der Drehbewegung des Griffs gekoppelt ist. Befindet sich das Griffstück in seiner Grundposition, so liegt der Gegenanschlag am Anschlag an, so dass die Vorderseite des Prüfsteckerblocks nicht nach unten verkippen kann, wenn der Monteur den Prüfsteckerblock am Griffstück festhält und horizontal auf den Reihenklemmenblock aufsteckt.

Um die Drehbewegung des Griffstücks in eine geradlinige Bewegung des mindestens einen Entriegelungselements umzuwandeln, ist gemäß einer vorteilhaften Ausgestaltung der Erfindung im Gehäuse des mindestens einen Befestigungsteils eine Getriebeanordnung angeordnet, über die das Entriegelungselement mit dem Griffstück verbunden ist. Hierzu sind im Gehäuse des mindestens einen Befestigungsteils vorzugsweise zwei miteinander in Eingriff stehende Zahnräder und eine Pleuelstange angeordnet, wobei das erste Zahnrad mit dem Griffstück und die Pleuelstange an einem Ende mit dem zweiten Zahnrad und am anderen Ende mit dem Entriegelungselement verbunden ist. Durch eine geeignete Wahl der beiden Zahnräder kann außerdem eine vorteilhafte Kraftübersetzung erzielt werden.

Gemäß einer bevorzugten Ausgestaltung der Erfindung ist im Gehäuse mindestens eines Befestigungsteils mindestens ein Anschlag ausgebildet ist, der mit einem am ersten Zahnrad oder am zweiten Zahnrad ausgebildeten korrespondierenden Gegenanschlag zusammenwirkt, so dass die mögliche Drehung des Griffstücks relativ zum Gehäuse begrenzt ist, wenn der Gegenanschlag am Anschlag anliegt. Grundsätzlich kann dabei ein zum Anschlag korrespondierender Gegenanschlag sowohl am ersten Zahnrad als auch am zweiten Zahnrad ausgebildet sein. Außerdem ist es auch möglich, dass an beiden Zahnrädern jeweils ein Gegenanschlag ausgebildet ist. Vorzugsweise ist der Gegenanschlag jedoch nur am ersten Zahnrad ausgebildet, das direkt mit dem Griffstück zusammenwirkt. In der nachfolgenden Beschreibung der vorliegenden Erfindung wird daher stets davon ausgegangen, dass der Gegenanschlag am ersten Zahnrad ausgebildet ist, ohne dass die Erfindung hierauf beschränkt sein soll.

Damit der im Gehäuse ausgebildete Anschlag eine gewollte Drehbewegung des Griffstücks nicht behindert, sind der im Gehäuse ausgebildete Anschlag und der am ersten Zahnrad ausgebildete Gegenanschlag in einer ersten Ebene und die Zähne des Zahnrades in einer zweiten Ebene angeordnet, die in Richtung der Drehachse des Zahnrades zur ersten Ebene versetzt ist. Dadurch ist gewährleistet, dass die Zähne des Zahnrades sich am Anschlag vorbeibewegen können, während der Gegenanschlag bei der entsprechenden Drehposition des Griffstücks bzw. der Zahnrades am Anschlag anstößt.

Gemäß einer bevorzugten Ausgestaltung der Erfindung sind im Gehäuse mindestens eines Befestigungsteils zwei Anschläge ausgebildet, die jeweils in einer bestimmten Drehposition des Zahnrads mit dem am ersten Zahnrad ausgebildeten Gegenanschlag zusammenwirken. Hierdurch kann die mögliche Drehbewegung des Griffstücks relativ zum Gehäuse weiter eingeschränkt werden, beispielsweise auf eine Drehbewegung von weniger als 180° oder vorzugsweise auf eine Drehbewegung von weniger als 120°.

Alternativ zur Ausbildung von zwei Anschlägen im Gehäuse mindestens eines Befestigungsteils können auch zwei Gegenanschläge an einem Zahnrad ausgebildet sein, wobei dann je nach Drehstellung des Zahnrades der eine Gegenanschlag oder andere Gegenanschlag an der ersten oder zweiten Seite des Anschlags anstößt. Ebenso ist es grundsätzlich auch möglich, dass eine entsprechende Begrenzung der möglichen Drehbewegung des Griffstücks dadurch gewährleistet wird, dass beide Zahnräde jeweils einen Gegenanschlag aufweisen und im Gehäuse zwei Anschläge ausgebildet sind, wobei der erste Anschlag mit dem Gegenanschlag des ersten Zahnrades und der zweite Anschlag mit dem Gegenanschlag des zweiten Zahnrades zusammenwirkt. Herstellungstechnisch und aus Platzgründen wird aber in der Regel vorteilhaft sein, wenn nur an einem Zahnrad, vorzugsweise dem ersten Zahnrad, ein Gegenanschlag und im Gehäuse zwei Anschläge ausgebildet sind, wobei der Gegenanschlag bei einer ersten Drehposition des Zahnrads am ersten Anschlag und bei einer zweiten Drehposition am zweiten Anschlag anstößt.

Gemäß einer weiteren vorteilhaften Ausgestaltung der Erfindung ist das Entriegelungselement derart ausgebildet und innerhalb des Gehäuses des Befestigungsteils angeordnet, dass das Entriegelungselement nicht nur in eine erste Entriegelungsposition und in eine zweite Entriegelungsposition verbracht werden kann, sondern darüber hinaus auch aus der ersten Entriegelungsposition weiter in eine dritte Position verschiebbar ist. Das Entriegelungselement ist dabei derart im Gehäuse positioniert, dass dann, wenn der Prüfsteckerblock auf einen Reihenklemmenblock aufgesteckt ist, die Unterkante des Entriegelungselements in der ersten Entriegelungsposition auf der Oberseite des Klemmengehäuses der Befestigungsklemme aufsitzt. Wird in dieser Position das Entriegelungselement aus der ersten Entriegelungsposition in Aufsteckrichtung des Befestigungsteils weiter in die dritte Position verschoben, so wird das Gehäuse des Befestigungsteils von dem Klemmengehäuse der Befestigungsklemme abgestoßen. Bei einer derartigen Ausgestaltung des Entriegelungselements fungiert dieses nicht nur zum Entriegeln der beiden Rastpositionen, sondern auch als Auswurf- bzw. Abziehhilfe beim Herausziehen des Prüfsteckerblocks aus dem Reihenklemmenblock. Bezüglich einer vorteilhaften Ausgestaltung eines derartigen Entriegelungselements wird auf die nachveröffentlichte DE 10 2012 017 429 verwiesen, die einen Prüfklemmenblock mit einem Reihenklemmenblock und einem ähnlichen Prüfsteckerblock offenbart.

Bei der zuvor beschriebenen Ausgestaltung des Prüfsteckerblocks bzw. des Befestigungsteils ist das Entriegelungselement durch eine Drehung des Griffstücks um einen Winkel α in eine erste Richtung im Gehäuse aus einer Grundposition in die erste Entriegelungsposition verschiebbar. Durch eine weitere Drehung des Griffstücks um einen Winkel β in dieselbe Richtung ist dann das Entriegelungselement in die dritte Position und durch Zurückdrehen des Griffstücks in die Grundposition in die zweite Entriegelungsposition verschiebbar.

Die Winkel α und β, um die das Griffstück in den beiden ersten Schritten gedreht wird, sind dabei so gewählt, dass das Drehen des Griffstücks vom Monteur einfach und bequem mit einer Hand erfolgen kann. Ein derartiges zweistufiges Verdrehen des Griffstücks um vorzugsweise weniger als 120°, beispielsweise ca. 90°, ist sehr einfach und bequem mit einer Hand durchführbar, ohne dass ein Umgreifen erforderlich ist. Die Winkel α und β können dabei im Wesentlichen gleich sein, beispielsweise jeweils ca. 45° betragen. Ebenso ist jedoch auch möglich, dass die beiden Winkel α und β unterschiedlich groß sind, beispielsweise der Winkel α ca. 20° bis 40° und der Winkel β ca. 50° bis 70° beträgt.

Dabei sind bei dem erfindungsgemäßen Prüfsteckerblock die zwei im Gehäuse ausgebildeten Anschläge und der am Zahnrad ausgebildete Gegenanschlag derart angeordnet, dass der Gegenanschlag in der Grundposition des Entriegelungselements am ersten Anschlag und in der dritten Position des Entriegelungselements am zweiten Anschlag anliegt. Durch die Ausbildung von zwei Anschlägen im Gehäuse und einem Gegenanschlag am Zahnrad wird das Handling des Prüfsteckerblocks für den Benutzer somit weiter vereinfacht, da dem Benutzer durch die beiden Anschlagspositionen der erforderliche Drehwinkel des Griffstücks zum richtigen Entriegeln und einfachen Abziehen des Prüfsteckerblocks vom Reihenklemmenblock einfach vorgegeben wird.

Gemäß einer weiteren besonders bevorzugten Ausgestaltung der Erfindung, die auch unabhängig von der Realisierung eines Begrenzungselements vorgesehen sein kann, ist das Entriegelungselement derart im Gehäuse des mindestens einen Befestigungsteils angeordnet ist, dass sich das Entriegelungselement in seiner Grundposition befindet, wenn das Griffstück nicht betätigt ist. Hierdurch ist sichergestellt, dass sich das Entriegelungselement stets in seiner Grundposition befindet, wenn der Benutzer das Griffstück des Prüfsteckerblocks nicht verdreht.

Besonders einfach kann dies dadurch realisiert sein, dass im Gehäuse des mindestens einen Befestigungsteils, das ein Entriegelungselement aufweist, mindestens ein Federelement derart angeordnet ist, dass das Entriegelungselement durch die Federkraft des Federelements in seine Grundposition verbracht wird, wenn das Griffstück nicht bestätigt ist. Dreht der Benutzer das Griffstück, so wird das Entriegelungselement entgegen der Federkraft des Federelements verschoben.

Um ein Verkanten des Entriegelungselements zu verhindern, sind vorzugsweise zwei Federelemente vorgesehen, wobei sich eine einfache und platzsparende Anordnung durch die Verwendung von zwei Druckfedern realisieren lässt, die sich jeweils mit ihrem einen Ende an einem Anschlag am Entriegelungselement und mit ihrem anderen Ende an einem Auflageabschnitt im Gehäuse abstützen.

Zuvor ist ausgeführt worden, dass der Einsteckabschnitt mindestens eines Befestigungsteils zwei Rastelemente aufweist, und dass im Gehäuse mindestens eines Befestigungsteils ein Entriegelungselement verschiebbar angeordnet sowie eine aus zwei Zahnrädern und einer Pleuelstange bestehende Getriebeanordnung vorgesehen sind. Auch wenn es grundsätzlich möglich ist, dass nur ein Befestigungsteil entsprechend ausgebildet ist, so sind gemäß der bevorzugten Ausgestaltung des erfindungsgemäßen Prüfsteckerblocks beide Befestigungsteile entsprechend ausgebildet, so dass sie jeweils die gewollte zweistufige Verrastung sowie deren Entriegelung mittels jeweils eines Entriegelungselements verwirklichen.

Hierzu weisen zunächst die Einsteckabschnitte beider Befestigungsteile jeweils zwei Rastelemente auf. Außerdem sind vorzugsweise auch im Gehäuse der beiden Befestigungsteile jeweils ein Entriegelungselement und eine aus zwei Zahnrädern und einer Pleuelstange bestehende Getriebeanordnung angeordnet. Weisen beide Befestigungsteile jeweils ein Entriegelungselement auf, so ist vorzugsweise vorgesehen, dass im Gehäuse der beiden Befestigungsteile auch jeweils mindestens ein Federelement angeordnet ist, durch dass das jeweilige Entriegelungselement mit einer Kraft beaufschlagt wird, die das Entriegelungselement in seine Grundposition verschiebt, wenn nicht das Griffteil entsprechend gedreht wird. Die bezüglich der Verrastung und der Entriegelung gleiche Ausbildung der beiden Befestigungsteile gewährleistet, dass es beim Aufstecken und insbesondere beim Abziehen des Prüfsteckerblocks vom Reihenklemmenblock nicht zu einem Verkanten kommen kann.

Die zuvor beschriebene Verhinderung des ungewollten Verkippens der Stirnseite des Prüfsteckerblocks beim Heranführen des Prüfsteckerblocks an den Reihenklemmenblock kann dagegen auch dann sicher verhindert werden, wenn nur im Gehäuse eines Befestigungsteils ein Begrenzungselement, insbesondere mindestens ein Anschlag ausgebildet ist, der mit einem korrespondierenden Gegenanschlag an einem Zahnrad zusammenwirkt. Selbstverständlich ist es jedoch auch möglich, dass beide Befestigungsteile auch bezüglich der Ausbildung des Begrenzungselements sind, d. h. beide Befestigungsteile vorzugsweise jeweils mindestens einen Anschlag und eine Gegenanschlag aufweisen.

Damit ein Benutzer die jeweilige Steckposition des Prüfsteckerblocks, d. h. die jeweilige Position des Einsteckabschnitts im Gehäuse eindeutig und einfacher erkennen kann, ist gemäß einer vorteilhaften Weiterbildung des erfindungsgemäßen Prüfsteckerblocks vorgesehen, dass im Gehäuse mindestens eines Befestigungsteils eine Positionsanzeige angeordnet ist. Die Positionsanzeige kann dadurch einfach als mechanische Anzeige ausgebildet sein, dass sie eine Positionsstange und ein Positionsrad aufweist, wobei ein mit Zähnen versehener Abschnitt der Positionsstange mit einem mit Zähnen versehenen Abschnitt des Positionsrades zusammen wirkt. Die Positionsstange ist dabei am Entriegelungselement verschiebbar angeordnet, wobei die mögliche Verschiebungsrichtung der Positionsstange parallel zur Aufsteckrichtung des Prüfsteckerblocks verläuft. Außerdem ist im Entriegelungselement - auf der dem Griffstück abgewandten Seite - eine Öffnung ausgebildet, durch die das in Aufsteckrichtung des Prüfsteckerblocks weisende freie Ende der Positionsstange herausragen kann. Zur Anzeige der jeweiligen Position des Einsteckabschnitts des Befestigungsteils im Klemmengehäuse einer Befestigungsklemme ist außerdem im Gehäuse des Befestigungsteils ein Sichtfenster ausgebildet, durch das ein Anzeigeabschnitt des Positionsrads von außerhalb des Gehäuses sichtbar ist.

Durch die von der jeweiligen Position des Einsteckabschnitts des Befestigungsteils im Klemmengehäuse einer Befestigungsklemme abhängige Position der Positionsstange wird das Positionsrad entsprechend gedreht, wobei die Position des Positionsrades durch das Sichtfenster erkennbar ist. Der Anzeigeabschnitt des Positionsrades weist dazu vorzugsweise mindestens drei Markierungen auf, bei denen es sich beispielsweise um unterschiedliche Farbmarkierungen oder unterschiedliche Zahlen oder Buchstaben handeln kann. Die erste Markierung ist dann im Bereich des Sichtfensters angeordnet, wenn der Einsteckabschnitt des Befestigungsteils nicht im Klemmengehäuse einer Befestigungsklemme eingesteckt oder zumindest nicht darin verrastet ist, so dass es vollständig aus dem Klemmengehäuse herausgezogen werden kann. Die zweite Markierung ist durch das Sichtfenster erkennbar, wenn der Einsteckabschnitt des Befestigungsteils vollständig im Klemmengehäuse der Befestigungsklemme eingesteckt ist. Befindet sich der Einsteckabschnitt des Befestigungsteils in seiner zweiten Rastposition, so ist die dritte Markierung im Bereich des Sichtfensters angeordnet.

Schließlich ist gemäß einer weiteren vorteilhaften Ausgestaltung des erfindungsgemäßen Prüfsteckerblocks im Gehäuse mindestens eines Befestigungsteils ein Steckzyklenzähler angeordnet, der die Anzahl der Steckzyklen des Prüfsteckers in einen Reihenklemmenblock anzeigt. Der Steckzyklenzähler kann beispielsweise ein mechanisches Zählwerk aufweisen, das über ein Sichtfenster im Gehäuse des Befestigungsteils von außen ablesbar ist, wobei das mechanische Zählwerk von einer verschiebbar im Gehäuse oder im Entriegelungselement angeordneten Stange betätigbar ist, deren freies Ende aus dem Gehäuse herausragt. Immer wenn der Prüfsteckerblock auf den Reihenklemmenblock aufgesteckt wird, wird die Stange ins Innere des Gehäuses gedrückt, wodurch das Zählwerk jedes Mal betätigt wird.

Im Einzelnen gibt es nun eine Vielzahl von Möglichkeiten, den erfindungsgemäßen Prüfsteckerblock auszugestalten und weiterzubilden. Dazu wird verwiesen sowohl auf die einzelnen Patentansprüche als auch auf die nachfolgende Beschreibung eines bevorzugten Ausführungsbeispiels in Verbindung mit der Zeichnung. In der Zeichnung zeigen
- Fig. 1: einen erfindungsgemäßen Prüfsteckerblock, in perspektivischer Darstellung,
- Fig. 2: einen Prüfsteckerblock und einen Reihenklemmenblock,
- Fig. 3: ein Befestigungsteil des Prüfklemmenblocks gemäß Fig. 1, in perspektivischer Darstellung,
- Fig. 4: das Befestigungsteil gemäß Fig. 3, mit geöffnetem Gehäuse,
- Fig. 5: einen vergrößerten Ausschnitt des Befestigüngsteils gemäß Fig. 4,
- Fig. 6: einen weiteren vergrößerten Ausschnitt des Befestigungsteils gemäß Fig. 4,
- Fig. 7: eine Befestigungsklemme des Reihenklemmenblocks gemäß Fig. 2 und das Befestigungsteil gemäß Fig. 4, in nicht aufgestecktem Zustand,
- Fig. 8: die Befestigungsklemme und das Befestigungsteil, im aufgesteckten Zustand, in der ersten Entriegelungsposition,
- Fig. 9: die Befestigungsklemme und das Befestigungsteil, im aufgesteckten Zustand, in der zweiten Position, und
- Fig. 10: das Befestigungsteil und eine Befestigungsklemme, in teilweise abgezogenen Zustand.

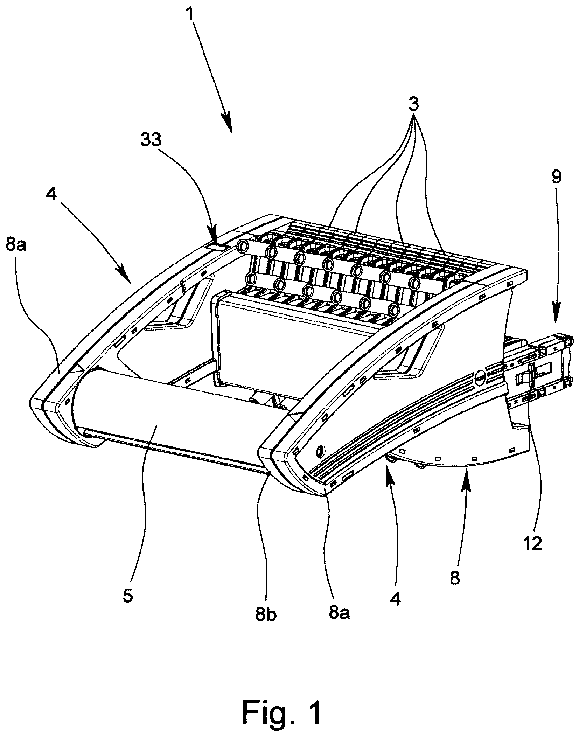

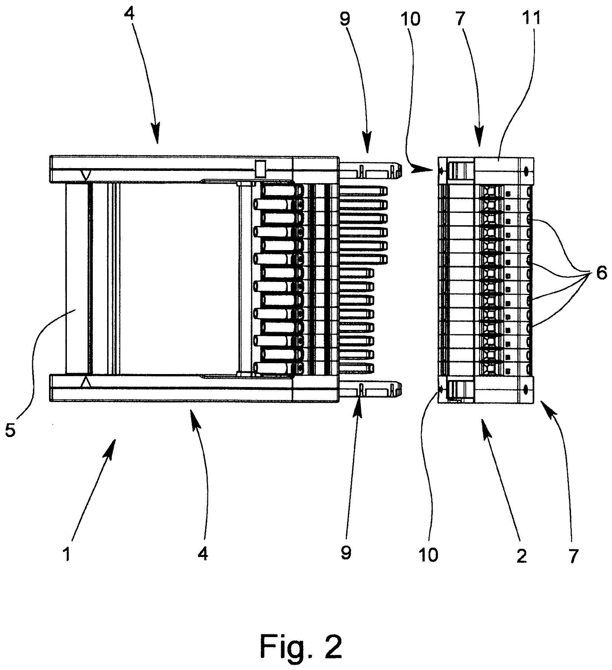

Der in Fig. 1 perspektivisch dargestellte Prüfsteckerblock 1 ist dafür vorgesehen, auf einen Reihenklemmenblock 2 (Fig. 2) aufgesteckt zu werden, wobei der Reihenklemmenblock 2 beispielsweise auf einer Tragschiene befestigt sein kann. Der Prüfsteckerblock 1 besteht aus einer Mehrzahl von miteinander verbundenen Prüfsteckern 3 und zwei Befestigungsteilen 4, die auf beiden Seiten der Mehrzahl von Prüfsteckern 3 angeordnet sind. Darüber hinaus weist der Prüfsteckerblock 1 noch ein Griffstück 5 auf, über dass die beiden Befestigungsteile 4 miteinander verbunden sind, wobei die Höhe der beiden Befestigungsteile 4 wesentlich größer als die Höhe der Prüfstecker 3 ist, so dass ein Monteur den Prüfsteckerblock 1 bequem am Griffstück 5 fassen und auf den Reihenklemmenblock 2 aufstecken kann.

Der Reihenklemmenblock 2 besteht seinerseits aus einer Mehrzahl von nebeneinander angeordneten Reihenklemmen 6 und zwei Befestigungsklemmen 7, die auf beiden Seiten der Mehrzahl von Reihenklemmen 6 angeordnet sind. Wie aus Fig. 2 erkennbar ist, entspricht dabei die Anzahl der Prüfstecker 3 der Anzahl der Reihenklemmen 6.

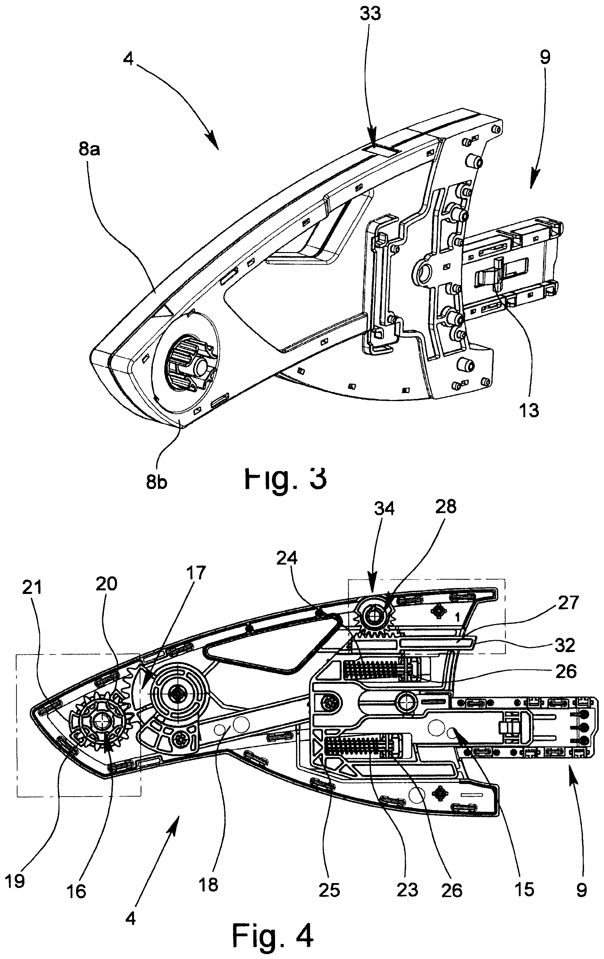

Das einzeln in Fig. 3 dargestellte Befestigungsteil 4 weist ein Gehäuse 8 auf, das aus zwei Gehäusehalbschalen 8a, 8b besteht, wobei bei der Darstellung des Befestigungsteils 4 in den Fig. 4 bis 10 jeweils die eine Gehäusehalbschale 8b weggelassen ist, so dass der innere Aufbau des Befestigungsteils 4 erkennbar ist. Zum Aufstecken des Prüfsteckerblocks 1 auf dem Reihenklemmenblock 2 weisen die beiden Befestigungsteile 4 jeweils einen Einsteckabschnitt 9 auf, der jeweils in einen korrespondierenden Aufnahmeabschnitt 10 im Klemmengehäuse 11 der beiden Befestigungsklemmen 7 einsteckbar ist.

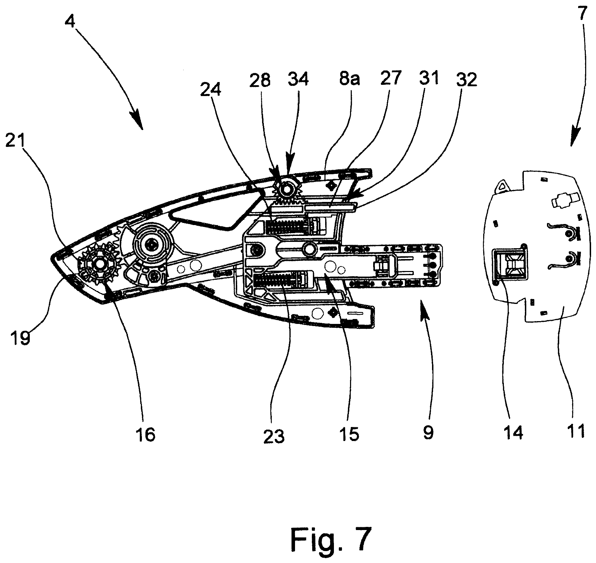

Wie aus einer Zusammenschau der Fig. 1 und 3 ersichtlich ist, sind am Einsteckabschnitt 9, auf den beiden einander gegenüberliegenden Seiten, zwei Rastelemente 12, 13 angeordnet, die jeweils von zwei Rasthaken gebildet werden. Die Rastelemente 12, 13 bilden zusammen mit zwei korrespondierenden Gegenrastelementen in den Befestigungsklemmen 7 eine erste und eine zweite Rastposition des Befestigungsteils 4 in der Befestigungsklemme 7, wobei die beiden Rastpositionen in Aufsteckrichtung des Prüfsteckerblocks 1 hintereinander angeordnet sind. Von den beiden, ebenfalls auf einander gegenüberliegenden Seiten im Klemmengehäuse 11 vorgesehenen Gegenrastelementen, die als Rastlaschen ausgebildet sind, ist in den Fig. 7 bis 10 jeweils nur ein Gegenrastelement 14 erkennbar.

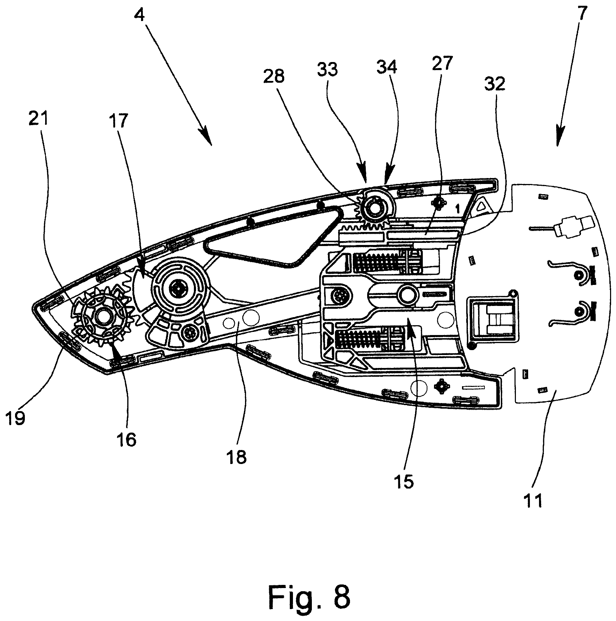

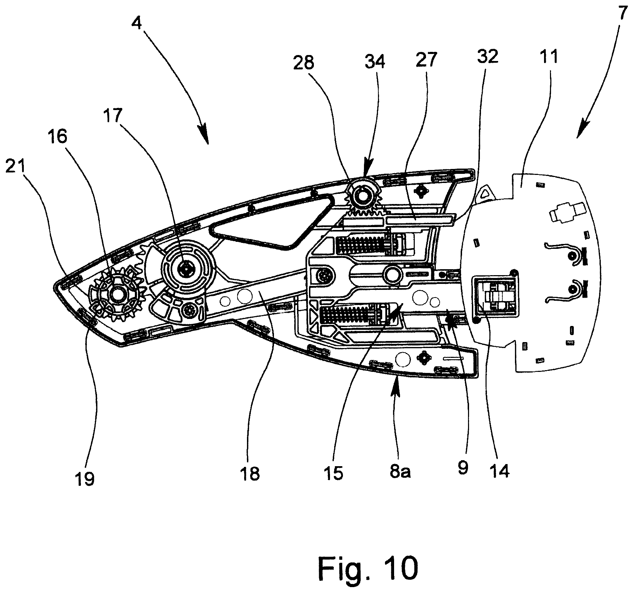

Wie insbesondere aus Fig. 4 sowie den Fig. 7 bis 10 ersichtlich ist, ist im Gehäuse 8, des Betätigungsteils 4 ein Entriegelungselement 15 verschiebbar angeordnet, das durch eine Drehbewegung des Griffstücks 5 aus einer Grundposition (Fig. 4, 7) in eine erste Entriegelungsposition' (Fig. 8) und eine zweite Entriegelungsposition (Fig. 10) verschoben werden kann. Das Entriegelungselement 15 dient dabei zum Lösen der Verriegelung der beiden Rastpositionen, wozu das Entriegelungselement 15 in der ersten Entriegelungsposition die Verriegelung der ersten Rastposition und in seiner zweiten Entriegelungsposition die Verriegelung der zweiten Rastposition löst, indem die jeweilige Rastlasche im Klemmengehäuse 11 der Befestigungsklemme 7 ausgelenkt wird, so dass das korrespondierende Rastelement 12, 13 nicht mehr durch das entsprechende Gegenrastelement verriegelt ist. Bezüglich einer möglichen konkreten, vorteilhaften Ausgestaltung der Rastelemente und der Gegenrastelemente sowie des Entriegelungselements wird auf die nachveröffentlichte DE 10 2012 017 429 verwiesen, die eine sehr ähnliche Verriegelungs- und Entriegelungsmechanik offenbart.

Um die Drehbewegung des Griffstücks 5 in eine - bei der in den Figuren dargestellten Ausrichtung des Prüfsteckerblocks 1 - horizontale Bewegung des Entriegelungselements 15 umzuwandeln, sind zwei miteinander in Eingriff stehende Zahnräder 16, 17 und eine Pleuelstange 18 im Gehäuse 8 angeordnet. Das erste Zahnrad 16 ist dabei mit dem Griffstück 5 drehfest gekoppelt, so dass eine Drehbewegung des Griffstücks 5 zu einer entsprechenden Drehbewegung des ersten Zahnrads 16 führt. Die Pleuelstange 18 ist an ihrem einen Ende mit dem zweiten Zahnrad 17 und an ihrem anderen Ende mit dem Entriegelungselement 15 verbunden, so dass eine Drehbewegung des Griffstücks 5 über die beiden Zahnräder 16, 17 und die Pleuelstange 18 zu einer horizontalen Verschiebung des Entriegelungselements 15 im Gehäuse 8 führt.

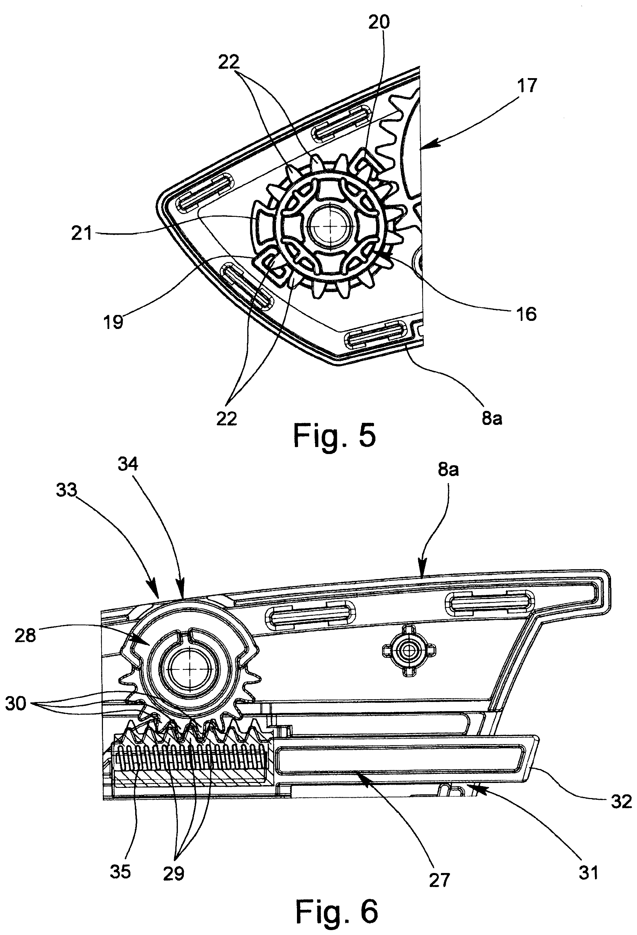

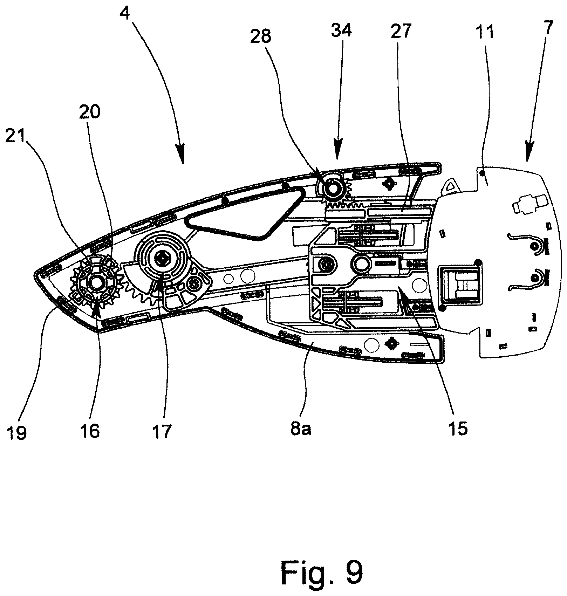

Insbesondere aus den Fig. 4 und 5 ist ersichtlich, dass im Gehäuse 8 des Befestigungsteils 4 zwei Anschläge 19, 20 ausgebildet sind, die mit einem am ersten Zahnrad 16 angeformten korrespondierenden Gegenanschlag 21 derart zusammenwirken, dass das Zahnrad 16 - und damit auch das Griffstück 5 - maximal um etwa 90° gedreht werden kann. In der in Fig. 4 und 7 dargestellten Grundposition des Entriegelungselements 15, in der das Griffstück 5 nicht verdreht ist, liegt der am ersten Zahnrad 16 ausgebildete Gegenanschlag 21 mit seiner einen Stirnseite am ersten Anschlag 19 an. In der in Fig. 9 dargestellten dritten Position des Entriegelungselements 15, in der das Griffstück 5 um etwa 90° im Vergleich zur Grundposition verdreht ist, liegt der Gegenanschlag 21 des ersten Zahnrads 16 mit seiner zweiten Stirnfläche am zweiten Anschlag 20 an. Durch die Anordnung und Ausbildung der beiden Anschläge 19, 20 sowie des Gegenanschlags 21 wird somit der maximale Drehwinkel des Griffstücks 5 festgelegt, wobei beide Endpositionen definierten Positionen des Entriegelungselements 15 entsprechen.

Aus der Darstellung gemäß Fig. 4 ist darüber hinaus erkennbar, dass durch die Ausbildung des ersten Anschlags 19 im Gehäuse 8 sowie die Anordnung des Gegenanschlags 21 am Zahnrad 16 verhindert wird, dass der Prüfsteckerblock 1 aufgrund seines Eigengewichts ungewollt im Uhrzeigersinn verkippt, wenn ein Monteur den Prüfsteckerblock 1 mit einer Hand am Griffstück 5 festhält und gemäß Fig. 7 waagerecht in Richtung des Reihenklemmenblocks 2 führt.

Damit beim gewollten Verdrehen des Griffstücks 5 und damit auch des Zahnrads 16 aus der in Fig. 7 dargestellten Grundposition in die in Fig. 9 dargestellte Position bzw. zurück in die in Fig. 10 dargestellte zweite Entriegelungsposition die Zähne 22 des Zahnrads 16 nicht gegen die Anschläge 19, 20 im Gehäuse 8 anstoßen, sind die beiden Anschläge 19, 20 sowie der Gegenanschlag 21 in einer ersten Ebene und die Zähne 22 des Zahnrades 16 in einer zweiten Ebene angeordnet, wobei die erste Ebene in Richtung der Drehachse des Zahnrades 16 versetzt zur zweiten Ebene ist. Wie aus Fig. 5 ersichtlich ist, können dadurch die Zähne 22 des ersten Zahnrads 16 an den beiden Anschlägen 19, 20 vorbeigeführt werden.

Aus Fig. 4 und den Fig. 7 bis 10 ist darüber hinaus erkennbar, dass zwei Druckfedern 23, 24 im Gehäuse 8 des Betätigungsteils 4 angeordnet sind, wobei sich die beiden Druckfedern 23, 24 jeweils mit ihrem Ende an einem Anschlag 25 am Entriegelungselement 15 und mit ihrem anderen Ende an einem Auflageabschnitt 26 im Gehäuseabschnitt 8 abstützen. Durch die Druckfedern 23, 24, die räumlich in das Entriegelungselement 15 integriert sind, wird das Entriegelungselement 15 mit einer Federkraft beaufschlagt, die das Entriegelungselement 15 in Richtung seiner Grundposition, d.h. bei der Darstellung gemäß Fig. 4 nach links, drückt. Beim Verdrehen des Griffstücks 5 aus der in Fig. 7 dargestellten Position in die beiden Positionen gemäß Fig. 8 und Fig. 9 muss somit eine Kraft aufgebracht werden, die größer als die Federkraft der beiden Druckfedern 23, 24 ist. Beim Verschieben des Entriegelungselements 15 aus der Position gemäß Fig. 7 in die Position gemäß Fig. 8 und Fig. 9, d. h. relativ zum Gehäuse 8 nach rechts, müssen die Druckfedern 23, 24 somit zusammengedrückt werden.

Zur Anzeige des Einsteck- bzw. Verriegelungszustandes des Prüfsteckerblocks 1 und damit zur Anzeige der Position des Einsteckabschnitts 9 eines Befestigungsteils 4 im Klemmengehäuse 11 einer Befestigungsklemme 7 weist die in den Figuren dargestellte bevorzugte Ausführungsform eines Befestigungsteils 4 eine Positionsanzeige auf. Wie wiederum aus der Fig. 4 sowie den Fig. 7 bis 10 und insbesondere der vergrößerten Darstellung gemäß Fig. 6 erkennbar ist, besteht die Positionsanzeige aus einer am Entriegelungselement 15 verschiebbar angeordneten Positionsstange 27 und einem drehbar im Gehäuse 8 gelagerten Positionsrad 28. Dabei steht ein mit Zähnen 29 versehener Abschnitt der Positionsstange 27 in Eingriff mit einem mit korrespondierenden Zähnen 30 versehenen Abschnitt des Positionsrades 28, so dass eine horizontale Verschiebung der Positionsstange 27 zu einer entsprechenden Verdrehung des Positionsrades 28 führt. Die Positionsstange 27 ist derart relativ zu einer im Entriegelungselement 15 ausgebildeten Öffnung 31 angeordnet, dass das in Aufsteckrichtung des Prüfsteckerblocks 1 weisende freie Ende 32 der Positionsstange 27 durch die Öffnung 31 herausragt, wenn der Prüfsteckerblock 1 nicht auf einen Reihenklemmenblock 2 aufgesteckt ist.

Ist dagegen der Prüfsteckerblock 1 auf einen Reihenklemmenblock 2 aufgesteckt (Fig. 8), so wird das freie Ende 32 der Positionsstange 27 durch die Oberkante der Befestigungsklemme 7 in das Entriegelungselement 15 zurückgedrückt, was gleichzeitig zu einer Verdrehung des Positionsrades 28 führt. Da im Gehäuse 8 des Befestigungsteils 4 gegenüberliegend zum Positionsrad 28 ein Sichtfenster 33 ausgebildet ist, ist der den Zähnen 30 gegenüberliegende Anzeigeabschnitt 34 durch das Sichtfenster 33 von außen für einen Monteur leicht erkennbar. Damit die Positionsstange 27 im nicht aufgesteckten Zustand immer mit ihrem freien Ende 32 aus der Öffnung 31 herausragt, ist ein Federelement 35 derart in dem Entriegelungselement 15 angeordnet, dass die Positionsstange 27 durch das Federelement 35 in Richtung der Öffnung 31 gedrückt wird.

Nachfolgend wird anhand der Fig. 7 bis 10 noch einmal kurz erläutert welche Positionen und Zustände das Befestigungsteil 4 aufweist, wenn der Prüfsteckerblock 1 auf einen Reihenklemmenblock 2 aufgesteckt bzw. abgezogen wird.

In der in Fig. 7 dargestellten Grundposition ist das Griffstück 5 nicht verdreht, so dass das Entriegelungselement 15 aufgrund der Federkraft der beiden Druckfedern 23, 24 ebenfalls in seine Grundposition - nach links - geschoben ist. Da der Gegenanschlag 21 am Anschlag 19 anliegt, wird ein Verkippen der Vorderseite des Prüfsteckerblocks 1 im Uhrzeigersinn aufgrund dessen Eigengewicht verhindert, so dass der Prüfsteckerblock 1 von einem Monteur einfach mit einer Hand am Griffstück 5 gehalten und in Richtung des Reihenklemmenblocks 2 geführt werden kann. Die Positionsstange 27 wird durch die Federkraft des Federelements 35 in Richtung der Öffnung 31 gedrückt, so dass das freie Ende 32 der Positionsstange 27 aus der Öffnung 31 herausragt.

Das Positionsrad 28 ist so gedreht, dass die erste (mittlere) Markierung des Anzeigeabschnitts 34 durch das Sichtfenster 33 erkennbar ist.

In Fig. 8 ist das Befestigungsteil 4 in der Position dargestellt, wenn der Prüfsteckerblock 1 vollständig auf den Reihenklemmenblock 2 aufgesteckt ist und außerdem das Griffstück 5 um einen Winkel α von ca. 30° gedreht ist: Durch die Drehung des Griffstücks 5 befindet sich das Entriegelungselement 15 in seiner ersten Entriegelungsposition, in der es etwas nach rechts verschoben ist, so dass das Entriegelungselement 15 die Verriegelung der ersten Rastposition löst. Hierzu wird das entsprechende Gegenrastelement im Klemmengehäuse 11 der Befestigungsklemme 7 durch das Entriegelungselement 15 etwas auslenkt, so dass das korrespondierende Rastelement 12 am Einsteckabschnitt 9 nicht mehr mit dem Gegenrastelement verrastet. Da das Befestigungsteil 4 auf der Befestigungsklemme 7 aufsitzt, wird das freie Ende 32 der Positionsstange 27 in das Entriegelungselement 15 zurückgedrückt, so dass das Positionsrad 28 durch die Verschiebung der Positionsstange 27 in Uhrzeigersinn gedreht wird. Durch das Sichtfenster 33 ist nun die zweite (obere) Markierung des Anzeigeabschnitts 34 sichtbar.

In der in Fig. 9 dargestellten Position des Prüfsteckerblocks 1 ist das Griffstück 5 weiter um einen Winkel β von ca. 60° gedreht, so dass sich das Entriegelungselement 15 in seiner dritten Position befindet. In dieser Position ist das Entriegelungselement 15 relativ zum Gehäuse 8 maximal verschoben. Da die Unterkante des Entriegelungselements 15 bereits in der ersten Entriegelungsposition gemäß Fig. 8 auf der Oberseite des Klemmengehäuses 11 der Befestigungsklemme 7 aufsitzt, führt das Verdrehen des Griffstücks 5 um den Winkel β dazu, dass das Gehäuse 8 des Befestigungsteils 4 von dem Klemmengehäuse 11 - nach links - abgestoßen wird. Ein weiteres Abziehen des Befestigungsteils 4 bzw. des Prüfsteckerblocks 1 wird durch die Verriegelung der zweiten Rastpostion verhindert, die in dieser Position noch nicht gelöst ist. Da nun der Gegenanschlag 21 am Anschlag 20 anliegt, wird eine weitere Drehung des Griffstücks 15 verhindert. Durch die maximale Verschiebung des Entriegelungselements 15 relativ zum Gehäuse 8 wird die Positionsstange 27 aufgrund der Federkraft des Federelements 35 ebenfalls relativ zum Gehäuse 8 maximal - nach rechts - verschoben, so dass das Positionsrad 28 nun maximal im Gegenuhrzeigersinn verdreht wird. Durch das Sichtfenster 33 ist die dritte (untere) Markierung des Anzeigeabschnitts 34 sichtbar.

Fig. 10 zeigt schließlich das Befestigungsteil 4 in der zweiten Entriegelüngsposition, in der das Griffstück 5 wieder in die Grundposition zurück gedreht ist. Der Gegenanschlag 21 am Zahnrad 16 liegt am ersten Anschlag 19 an. Das Entriegelungselement 15 in nun wieder nach links in des Gehäuse 8 verschoben, wobei das Entriegelungselement 15 die Verriegelung der ersten Rastposition löst. Hiebei wird das als Rastlasche ausgebildete Gegenrastelement 14 im Klemmengehäuse 11 der Befestigungsklemme 7 durch das Entriegelungselement 15 etwas auslenkt, so dass das korrespondierende Rastelement 13 am Einsteckabschnitt 9 nicht mehr mit dem Gegenrastelement 14 verrastet. Der Prüfsteckerblock 1 kann nun ganz von dem Reihenklemmenblock 2 abgezogen werden. Mit dem Entriegelungselement 15 wird auch die Positionsstange 27 wieder in das Gehäuse 8 verschoben, so dass sich das Positionsrad 28 wieder in Uhrzeigersinn in seine Ausgangsposition dreht, in der die erste (mittlere) Markierung des Anzeigeabschnitts 34 durch das Sichtfenster 33 erkennbar ist.

## Patentansprüche

1. Prüfsteckerblock zum Aufstecken auf einen Reihenklemmenblock (2), mit einer Mehrzahl von miteinander verbundenen Prüfsteckern (3) und zwei auf beiden Seiten der Mehrzahl von Prüfsteckern (3) angeordneten Befestigungsteilen (4), die über ein Griffstück (5) miteinander verbunden sind, wobei die Befestigungsteile (4) jeweils ein Gehäuse (8) mit einem Einsteckabschnitt (9) aufweisen, der in einen Aufnahmeabschnitt (10) einsteckbar ist, der im Klemmengehäuse (11) einer Befestigungsklemme (7) des Reihenklemmenblocks (2) ausgebildet ist,
**dadurch gekennzeichnet,**
**dass** der Einsteckabschnitt (9) mindestens eines Befestigungsteils (4) mindestens zwei Rastelemente (12, 13) aufweist, die mit korrespondierenden Gegenrastelementen (14) der Befestigungsklemme (7) zusammen eine erste Rastposition und eine zweite Rastposition des Befestigungsteils (4) in der Befestigungsklemme (7) festlegen, wobei die beiden Rastpositionen in Aufsteckrichtung des Prüfsteckerblocks (1) hintereinander angeordnet sind, so dass der Prüfsteckerblock (1) sowohl in seiner vollständig auf den Reihenklemmenblock (2) aufgesteckten Position als auch in einer zweiten, teilweise herausgezogenen Position verriegelt werden kann,
**dass** im Gehäuse (8) des mindestens einen Befestigungsteils (4) ein Entriegelungselement (15) verschiebbar angeordnet ist, das durch eine Drehbewegung des Griffstücks (8) aus einer Grundposition in eine erste Entriegelungsposition und durch eine weitere Drehbewegung des Griffstücks (8) in eine zweite Entriegelungsposition verbringbar ist, wobei in der ersten Entriegelungsposition eine Verriegelung zwischen dem Rastelement (12) und dem Gegenrastelement (14) der ersten Rastposition und in der zweiten Entriegelungsposition eine Verriegelung zwischen dem Rastelement (13) und dem Gegenrastelement der zweiten Rastposition durch das Entriegelungselement (15) gelöst ist, und
**dass** mindestens ein Befestigungsteil (4) mindestens ein Begrenzungselement aufweist, das die mögliche Drehung des Griffstücks (5) relativ zum Gehäuse (8) begrenzt.

2. Prüfsteckerblock nach Anspruch 1, **dadurch gekennzeichnet, dass** im Gehäuse (8) des mindestens einen Befestigungsteils (4) eine Getriebeanordnung angeordnet ist, über die das Entriegelungselement (15) mit dem Griffstück (8) verbunden ist.

3. Prüfsteckerblock nach Anspruch 2, **dadurch gekennzeichnet, dass** die Getriebeanordnungen zwei miteinander in Eingriff stehende Zahnräder (16, 17) und eine Pleuelstange (18) aufweist, wobei das erste Zahnrad (16) mit dem Griffstück (5) und die Pleuelstange (18) an einem Ende mit dem zweiten Zahnrad (17) und am anderen Ende mit dem Entriegelungselement (15) verbunden ist.

4. Prüfsteckerblock nach Anspruch 3, **dadurch gekennzeichnet, dass** im Gehäuse (8) des mindestens einen Befestigungsteils (4) mindestens ein Anschlag (19, 20) als Begrenzungselement ausgebildet ist, der mit einem am ersten Zahnrad (16) oder am zweiten Zahnrad (17) ausgebildeten korrespondierenden Gegenanschlag (21) zusammenwirkt, so dass die mögliche Drehung des Griffstücks (5) relativ zum Gehäuse (8) begrenzt ist.

5. Prüfsteckerblock nach Anspruch 4, **dadurch gekennzeichnet, dass** der mindestens eine im Gehäuse (8) ausgebildete Anschlag (19) und der am ersten Zahnrad (16) oder am zweiten Zahnrad (17) ausgebildete Gegenanschlag (21) in einer ersten Ebene und die Zähnen (22) des Zahnrades (16) in einer, in Richtung der Drehachse des Zahnrades (16) zur ersten Ebene versetzten zweiten Ebene angeordnet sind.

6. Prüfsteckerblock nach Anspruch 4 oder 5, **dadurch gekennzeichnet, dass** im Gehäuse (8) mindestens eines Befestigungsteils (4) zwei Anschläge (19, 20) ausgebildet sind, die mit dem am ersten Zahnrad (16) oder am zweiten Zahnrad (17) ausgebildeten Gegenanschlag (21) zusammenwirken, wobei die mögliche Drehung des Griffstücks (5) relativ zum Gehäuse (8) vorzugsweise auf einen Drehbewegung von weniger als 180°, insbesondere von weniger als 120° begrenzt ist.

7. Prüfsteckerblock nach Anspruch 6, **dadurch gekennzeichnet, dass** durch eine Drehung des Griffstücks (5) um einen Winkel α in eine erste Richtung das Entriegelungselement (15) im Gehäuse (8) des mindestens einen Befestigungsteils (4) aus einer Grundposition in die erste Entriegelungsposition, durch eine weitere Drehung des Griffstücks (5) um einen Winkel β in dieselbe Richtung das Entriegelungselement (15) weiter in eine dritte Position und durch Zurückdrehen des Griffstücks (5) in die Grundposition das Entriegelungselement (15) in die zweite Entriegelungsposition verschiebbar ist, wobei der Gegenanschlag (21) in der Grundposition des Entriegelungselements (15) am ersten Anschlag (19) und in der dritten Position des Entriegelungselements (15) am zweiten Anschlag (20) anliegt.

8. Prüfsteckerblock zum Aufstecken auf einen Reihenklemmenblock (2), mit einer Mehrzahl von miteinander verbundenen Prüfsteckern (3) und zwei auf beiden Seiten der Mehrzahl von Prüfsteckern (3) angeordneten Befestigungsteilen (4), die über ein Griffstück (5) miteinander verbunden sind, wobei die Befestigungsteile (4) jeweils ein Gehäuse (8) mit einem Einsteckabschnitt (9) aufweisen, der in einen Aufnahmeabschnitt (10) einsteckbar ist, der im Klemmengehäuse (11) einer Befestigungsklemme (7) des Reihenklemmenblocks (2) ausgebildet ist, nach einem der Ansprüche 1 bis 7, **dadurch gekennzeichnet, dass** das Entriegelungselement (15) derart im Gehäuse (8) des mindestens einen Befestigungsteils (4) angeordnet ist, dass sich das Entriegelungselement (15) in seiner Grundposition befindet, wenn das Griffstück (5) nicht betätigt ist.

9. Prüfsteckerblock nach Anspruch 8, **dadurch gekennzeichnet, dass** im Gehäuse (8) des mindestens einen Befestigungsteils (4) mindestens ein Federelement (23) derart angeordnet ist, dass das Entriegelungselement (15) durch die Federkraft des Federelements (23) in seine Grundposition verbracht wird, wenn das Griffstück (5) nicht betätigt ist.

10. Prüfsteckerblock nach Anspruch 9, **dadurch gekennzeichnet, dass** im Gehäuse (8) des mindestens einen Befestigungsteils (4) zwei Druckfedern (23, 24) angeordnet sind, wobei sich beide Druckfedern (23, 24) jeweils mit ihrem einen Ende an einem Anschlag (25) am Entriegelungselement (15) und mit ihrem anderen Ende an einem Auflageabschnitt (26) im Gehäuse (8) abstützen.

11. Prüfsteckerblock nach einem der Ansprüche 1 bis 10, **dadurch gekennzeichnet, dass** im Gehäuse (8) mindestens eines Befestigungsteiles (4) eine Positionsanzeige angeordnet ist, die die jeweilige Position des Einsteckabschnitts (9) des Befestigungsteils (4) im Klemmengehäuse (11) einer Befestigungsklemme (7) anzeigt.

12. Prüfsteckerblock nach Anspruch 11, **dadurch gekennzeichnet, dass** die Positionsanzeige eine am Entriegelungselement (15) parallel zur Aufsteckrichtung des Prüfsteckerblocks (1) verschiebbar angeordnete Positionsstange (27) und ein im Gehäuse (8) drehbar gelagertes Positionsrad (28) aufweist, wobei ein mit Zähnen (29) versehener Abschnitt der Positionsstange (27) mit einem mit Zähnen (30) versehenen Abschnitt des Positionsrades (28) in Eingriff steht,
dass im Entriegelungselement (15) eine Öffnung (31) ausgebildet ist, durch die das in Aufsteckrichtung des Prüfsteckerblocks (1) weisende freie Ende (32) der Positionsstange (27) herausragen kann, und
dass im Gehäuse (8) des Befestigungsteils (4) ein Sichtfenster (33) ausgebildet ist, durch das ein Anzeigeabschnitt (34) des Positionsrads (28) von außerhalb des Gehäuses (8) sichtbar ist.

13. Prüfsteckerblock nach Anspruch 12, **dadurch gekennzeichnet, dass** im Gehäuse (8) des Befestigungsteils (4), in dem eine Positionsanzeige vorgesehen ist, ein Federelement (35) derart angeordnet ist, dass die Positionsstange (27) durch das Federelement (35) mit einer Kraft in Richtung der Öffnung (31) im Entriegelungselement (15) beaufschlagt ist.

14. Prüfsteckerblock nach Anspruch 12 oder 13, **dadurch gekennzeichnet, dass** der Anzeigeabschnitt (34) des Positionsrads (28) mindestens drei unterschiedliche Markierungen aufweist, die unterschiedlichen Positionen des Einsteckabschnitts (9) des Befestigungsteils (4) im Klemmengehäuse (11) einer Befestigungsklemme (7) zugeordnet sind.

15. Prüfsteckerblock nach einem der Ansprüche 1 bis 14, **dadurch gekennzeichnet, dass** im Gehäuse (8) mindestens eines Befestigungsteiles (4) ein Steckzyklenzähler angeordnet ist, der die Anzahl der Steckzyklen des Prüfsteckers (1) in einen Reihenklemmenblock (2) anzeigt.

## Claims

1. Test plug block for slipping onto a modular terminal block (2), with a plurality of interconnected test plugs (3) and two fastening parts (4) which are located on either side of the plurality of test plugs (3) and which are connected to one another via a handle (5), wherein the fastening parts (4) each have a housing (8) with a plug-in section (9) which can be plugged into a receiving section (10) which is made in the clip housing (11) of a mounting clip (7) of the modular terminal block (2),
**characterized in**
**that** the plug-in section (9) of at least one fastening part (4) has at least two latching elements (12, 13) which with corresponding opposed latching elements (14) of the mounting clip (7) together fix a first latching position and a second latching position of the fastening part (4) in the mounting clip (7), the two latching positions being arranged behind one another in the slip-on direction of the test plug block (1), so that the test plug block (1) can be latched both in its position completely slipped onto the terminal block (2) as well as in a second, partially pulled-out position,
**that**, in the housing (8) of at least one fastening part (4), an unlocking element (15) is movably arranged which can be moved by a rotary motion of the handle (5) out of a base position into a first unlocking position and by a second rotary motion of the handle (5) into another unlocking position, wherein in the first unlocking position, the locking between the latching element (12) and the opposed latching element (14) of the first latching position and in the second unlocking position, the locking between the latching element (13) and the opposed latching element of the second latching position are released by the unlocking element (15), and
**that** at least one fastening part (4) has at least one limiting element which limits the possible rotation of the handle (5) relative to the housing (8).

2. Test plug block according to claim 1, **characterized in that** in the housing (8) of at least one fastening part (4) there is a gear train arrangement via which the unlocking element (15) is connected to the handle (8).

3. Test plug block according to claim 2, **characterized in that** the gear train arrangement has two gear wheels (16, 17) which engage one another and one connecting rod (18), wherein the first gear wheel (16) is connected to the handle (5) and the connecting rod (18) is connected on one end to the second gear wheel (17) and on the other end to the unlocking element (15).

4. Test plug block according to claim 3, **characterized in that** in the housing (8) of at least one fastening part (4) at least one stop (19, 20) is made as a limiting element, which interacts with a corresponding counter stop (21) which has been made on the first gear wheel (16) or on the second gear wheel (17) so that the possible rotation of the handle (5) relative to the housing (8) is limited.

5. Test plug block according to claim 4, **characterized in that** at least one stop (19) which is made in the housing (8) and the counter stop (21) which is made on the first gear wheel (16) or on the second gear wheel (17) are located in a first plane and the teeth (22) of the gear wheel (16) are located in second plane, which is offset to the first plane in the direction of the axis of rotation of the gear wheel (16).

6. Test plug block according to claim 4 or 5, **characterized in that** in the housing (8) of at least one fastening part (4), two stops (19, 20) are made which interact with the counter stop (21) made on the first gear wheel (16) or on the second gear wheel (17), wherein the possible rotation of the handle (5) relative to the housing (8) is limited preferably to rotary motion of less than 180°, in particular of less than 120°.

7. Test plug block according to claim 6, **characterized in that** by rotating the handle (5) by an angle α in a first direction the unlocking element (15) in the housing (8) of at least one fastening part (4) can be moved out of a base position into the first unlocking position, by further rotation of the handle (5) by an angle β in the same direction the unlocking element (15) can be moved further into a third position and by turning the handle (5) back into the base position the unlocking element (15) can be moved into the second unlocking position, wherein the counter stop (21) in the base position of the unlocking element (15) adjoins the first stop (19) and in the third position of the unlocking element (15) adjoins the second stop (20).

8. Test plug block for slipping onto a modular terminal block (2), with a plurality of interconnected test plugs (3) and two fastening parts (4) which are located on either side of the plurality of test plugs (3) and which are connected to one another via a handle (5), wherein the fastening parts (4) each have a housing (8) with a plug-in section (9) which can be plugged into a receiving section (10) which is made in the clip housing (11) of a mounting clip (7) of the modular terminal block (2), according to any one of claims 1 to 7,
**characterized in**
**that** the unlocking element (15) is located in the housing (8) of at least one fastening part (4) such that the unlocking element (15) is in its base position when the handle (5) has not been actuated.

9. Test plug block according to claim 8, **characterized in that** in the housing (8) of at least one fastening part (4) there is at least one spring element (23) arranged such that the unlocking element (15) is moved into its base position by the spring force of the spring element (23) when the handle (5) has not been actuated.

10. Test plug block according to claim 9, **characterized in that** there are two compression springs (23, 24) in the housing (8) of at least one fastening part (4), wherein the two compression springs (23, 24) each with their one end are supported on a stop (25) on the unlocking element (15) and with their other end on a bearing section (26) in the housing (8).

11. Test plug block according to any one of claims 1 to 10, **characterized in that** in the housing (8) of at least one fastening part (4), there is a position indication which indicates the respective position of the plug-in section (9) of the fastening part (4) in the clip housing (11) of one mounting clip (7).

12. Test plug block according to claim 11, **characterized in that** the position indication has a position rod (27) which is movably arranged at the unlocking element (15) parallel to the slip-on direction of the test plug block (1) and a position wheel (28) which is pivotally mounted in the housing (8), wherein a section of the positioning rod (27) which is provided with teeth (29) engages a section of the position wheel (28) which is provided with teeth (30),
that in the unlocking element (15) an opening (31) is made through which the free end (32) of the position rod (27) which points in the slip-on direction of the test plug block (1) can protrude, and
that in the housing (8) of the fastening part (4) a viewing window (33) is made through which an indication section (34) of the position wheel (28) is visible from outside the housing (8).

13. Test plug block according to claim 12, **characterized in that** in the housing (8) of the fastening part (4), in which there is a position indication, a spring element (35) is arranged such that the position rod (27) is exposed to a force by the spring element (35) in the direction of the opening (31) in the unlocking element (15).

14. Test plug block according to claim 12 or 13, **characterized in that** the indication section (34) of the position wheel (28) has at least three different markings which are assigned to different positions of the plug-in section (9) of the fastening part (4) in the clip housing (11) of a mounting clip (7).

15. Test plug block according to any one of claims 1 to 14, **characterized in that** in the housing (8) of at least one fastening part (4) there is a plug-in cycle counter, which displays the number of plug-in cycles of the test plug (1) into a modular terminal block (2).

## Revendications

1. Bloc de fiches de test destiné à être enfiché sur un bloc de bornes en série (2), comprenant une pluralité de fiches de test (3) interconnectées et deux éléments de fixation (4) qui sont disposés des deux côtés de la pluralité de fiches de test (3) et qui sont reliés entre eux par une pièce de préhension (5), dans lequel les éléments de fixation (4) comportent respectivement un boîtier (8) pourvu d'une partie d'enfichage (9) pouvant être enfichée dans une partie de réception (10) qui est réalisée dans le boîtier (11) d'une borne de fixation (7) du bloc de bornes en série (2),
**caractérisé en ce que**
la partie d'enfichage (9) d'au moins un élément de fixation (4) comporte au moins deux éléments d'encliquetage (12, 13) qui définissent, conjointement avec des éléments d'encliquetage antagonistes (14) de la borne de fixation (7), une première position d'encliquetage et une deuxième position d'encliquetage de l'élément de fixation (4) dans la borne de fixation (7), dans lequel les deux positions d'encliquetage sont disposées l'une derrière l'autre dans la direction d'enfichage du bloc de fiches de test (1), de manière à ce que le bloc de fiches de test (1) puisse être verrouillé à la fois à sa position complètement enfichée sur le bloc de bornes (2) et à une deuxième position partiellement dégagée,
**en ce que**, dans le boîtier (8) dudit au moins un élément de fixation (4) est disposé, de manière mobile, un élément de déverrouillage (15) qui peut être amené, par un mouvement de rotation de la pièce de préhension (5), d'une position de base à une première position de déverrouillage et à une deuxième position de déverrouillage par un autre mouvement de rotation de la pièce de préhension (5), dans lequel, à la première position de déverrouillage, un verrouillage est libéré entre l'élément d'encliquetage (12) et l'élément d'encliquetage antagoniste (14) à la première position de verrouillage et, à la deuxième position de déverrouillage, un verrouillage est libéré entre l'élément d'encliquetage (13) et l'élément d'encliquetage antagoniste à la deuxième position de verrouillage par l'élément de déverrouillage (15), et
**en ce qu'**au moins un élément de fixation (4) comporte au moins un élément de limitation qui limite la rotation éventuelle de la pièce de préhension (5) par rapport au boîtier (8).

2. Bloc de fiches de test selon la revendication 1, **caractérisé en ce qu'**un système d'engrenages, par l'intermédiaire duquel l'élément de déverrouillage (15) est relié à la pièce de préhension (8), est disposé dans le boîtier (8) dudit au moins un élément de fixation (4).

3. Bloc de fiches de test selon la revendication 2, **caractérisé en ce que** les systèmes d'engrenages comportent deux roues dentées (16, 17) en prise l'une avec l'autre et une bielle (18), dans lequel la première roue dentée (16) est reliée à la pièce de préhension (5) et la bielle (18) est reliée, au niveau d'une extrémité, à la deuxième roue dentée (17) et, au niveau de l'autre extrémité, à l'élément de déverrouillage (15).

4. Bloc de fiches de test selon la revendication 3, **caractérisé en ce que**, dans le boîtier (8) dudit au moins un élément de fixation (4) est réalisé, en tant qu'élément de limitation, au moins une butée (19, 20) qui coopère avec une contre-butée correspondante (21) réalisée sur la première roue dentée (16) ou sur la deuxième roue dentée (17), de manière à limiter l'éventuelle rotation de la pièce de préhension (5) par rapport au boîtier (8).

5. Bloc de fiches de test selon la revendication 4, **caractérisé en ce que** ladite au moins une butée (19) réalisée dans le boîtier (8) et la contre-butée (21) réalisée sur la première roue dentée (16) ou sur la deuxième roue dentée (17) sont disposées dans un premier plan et **en ce que** les dents (22) de la roue dentée (16) sont disposées dans un deuxième plan décalé dans la direction de l'axe de rotation de la roue dentée (16) par rapport au premier plan.

6. Bloc de fiches de test selon la revendication 4 ou 5, **caractérisé en ce que** deux butées (19, 20), qui coopèrent avec la contre-butée (21) réalisée sur la première roue dentée (16) ou sur la seconde roue dentée (17), sont réalisées dans le boîtier (8) d'au moins un élément de fixation (4), dans lequel l'éventuelle rotation de la pièce de préhension (5) par rapport au boîtier (8) est de préférence limitée à un mouvement de rotation inférieur à 180°, en particulier inférieur à 120°.

7. Bloc de fiches de test selon la revendication 6, **caractérisé en ce que** l'élément de déverrouillage (15) peut être amené à passer d'une position de base à la première position de déverrouillage dans le boîtier (8) dudit au moins un élément de fixation (4), par une rotation de la pièce de préhension (5) d'un angle α dans une première direction, l'élément de déverrouillage (15) peut en outre être amené à passer à une troisième position par une rotation supplémentaire de la pièce de préhension (5) d'un angle β dans la même direction,
et l'élément de déverrouillage (15) peut être amené à passer à la deuxième position de déverrouillage en ramenant la pièce de préhension (5) à la position de base, dans lequel la contre-butée (21) appuie contre la première butée (19) à la position de base de l'élément de déverrouillage (15) et contre la deuxième butée (20) à la troisième position de l'élément de déverrouillage (15).

8. Bloc de fiches de test destiné à être enfiché sur un bloc de bornes en série (2), comprenant une pluralité de fiches de test (3) interconnectées et deux éléments de fixation (4) qui sont disposés des deux côtés de la pluralité de fiches de test (3) et qui sont reliés entre eux par une pièce de préhension (5), dans lequel les éléments de fixation (4) comportent respectivement un boîtier (8) pourvu d'une partie d'enfichage (9) pouvant être enfichée dans une partie de réception (10) qui est réalisée dans le boîtier (11) d'une borne de fixation (7) du bloc de bornes en série (2), selon l'une des revendications 1 à 7,
**caractérisé en ce que** l'élément de déverrouillage (15) est disposé dans le boîtier (8) dudit au moins un élément de fixation (4) de manière à ce que l'élément de déverrouillage (15) se trouve à sa position de base lorsque la pièce de préhension (5) n'est pas actionnée.

9. Bloc de fiches de test selon la revendication 8, caractérisé en ce en ce qu'au moins un élément à ressort (23) est disposé dans le boîtier (8) dudit au moins un élément de fixation (4) de manière à ce que l'élément de déverrouillage (15) soit amené à sa position de base par la force de rappel de l'élément à ressort (23) lorsque la pièce de préhension (5) n'est pas actionnée.

10. Bloc de fiches de test selon la revendication 9, **caractérisé en ce que** deux ressorts de compression (23, 24) sont disposés dans le boîtier (8) dudit au moins un élément de fixation (4), dans lequel les deux ressorts de compression (23, 24) appuient respectivement par l'une de leurs extrémités au niveau d'une butée (25) sur l'élément de déverrouillage (15) et par leur autre extrémité sur une partie de support (26) dans le boîtier (8).

11. Bloc de fiches de test selon l'une des revendications 1 à 10, **caractérisé en ce qu'**un afficheur de position, qui indique la position respective de la partie d'enfichage (9) de l'élément de fixation (4) dans le boîtier de borne (11) d'une borne de fixation (7), est disposé dans le boîtier (8) dudit au moins un élément de fixation (4).

12. Bloc de fiches de test selon la revendication 11, **caractérisé en ce que** l'indicateur de position comporte une tige de position (27) qui est disposée de manière mobile sur l'élément de déverrouillage (15) parallèlement à la direction du bloc de fiches de test (1) et une roue de position (28) qui est montée tournante dans le boîtier (8), dans lequel une partie de la tige de position (27) pourvue de dents (29) s'engage avec une partie de la roue de position (28) pourvue de dents (30),
**en ce qu'**une ouverture (31), à travers laquelle peut faire saillie l'extrémité libre (32) de la tige de position (27) qui est orientée dans la direction d'enfichage du bloc de bornes de test (1) de la fiche de test, est ménagée dans l'élément de déverrouillage (15), et
**en ce qu'**une fenêtre d'observation (33), à travers laquelle une partie indicatrice (34) de la roue de position (28) est visible de l'extérieur du boîtier (8), est réalisée dans le boîtier (8) de l'élément de fixation (4).

13. Bloc de fiches de test selon la revendication 12, **caractérisé en ce qu'**un élément à ressort (35) est disposé dans le boîtier (8) de l'élément de fixation (4), dans lequel il est prévu un indicateur de position, de manière à ce que la tige de position (27) soit sollicitée par l'élément à ressort (35) avec une force exercée dans la direction de l'ouverture (31) ménagée dans l'élément de déclenchement (15).

14. Bloc de fiches de test selon la revendication 12 ou 13, **caractérisé en ce que** la partie d'affichage (34) de la roue de position (28) présente au moins trois repères différents qui sont associés à des positions différentes de la partie d'enfichage (9) de l'élément de fixation (4) dans le boîtier de borne (11) d'une borne de fixation (7).

15. Bloc de fiches de test selon l'une des revendications 1 à 14, **caractérisé en ce qu'**un compteur de cycles d'enfichage, qui indique le nombre de cycles d'enfichage de la fiche de test (1) dans un bloc de bornes en série (2), est disposé dans le boîtier (8) d'au moins un élément de fixation (4).
